# EUROPÄISCHE PATENTSCHRIFT

(11) **EP 2 719 020 B1**
(45) Veröffentlichungstag und Bekanntmachung des Hinweises auf die Patenterteilung: **20.09.2017**
(21) Anmeldenummer: 12716023.2
(22) Anmeldetag: 23.04.2012
(51) Int. Cl.: H01R 12/71, H05K 1/11, H01R 12/72, H01R 13/24

(54) **DIREKTSTECKELEMENT MIT GESCHÜTZTEM DIREKTKONTAKT**
DIRECT PLUG ELEMENT WITH A PROTECTED DIRECT CONTACT
ÉLÉMENT À EMMANCHEMENT DIRECT À CONTACT DIRECT PROTÉGÉ

(30) Priorität: 06.06.2011 DE 102011076988
(43) Veröffentlichungstag der Anmeldung: 16.04.2014
(73) Patentinhaber: Robert Bosch GmbH, 70442 Stuttgart (DE)
(72) Erfinder: WITTMANN, Rolf, 71638 Ludwigsburg (DE)
(86) Internationale Anmeldenummer: PCT/EP2012/057381
(87) Internationale Veröffentlichungsnummer: WO 2012/167985

(56) Entgegenhaltungen:
- EP-A1- 2 096 718
- US-A- 5 676 562

## Beschreibung

### Stand der Technik

Die vorliegende Erfindung betrifft ein Direktsteckelement mit einem geschützten Direktkontakt sowie eine elektrische Anordnung mit einem erfindungsgemäße Direktsteckelement.

In jüngster Zeit werden vermehrt Direktsteckkontakte verwendet, bei denen ein Direktsteckelement unmittelbar auf eine Trägerplatte, z.B. eine Leiterplatte oder ein Stanzgitter, gesteckt wird. Insbesondere bei einer Verwendung im Fahrzeugbereich ergeben sich jedoch erhöhte Anforderungen hinsichtlich einer Robustheit und Lebensdauer derartiger Direktsteckverbindungen. Bisher ragt eine Kontaktlamelle des Direktkontaktes weitgehend ungeschützt aus einem Gehäuse des Direktsteckelements heraus. Hierdurch können Beschädigungen beim Transport, der Verarbeitung oder der Bestückung, d.h. der Montage der Direktkontakte in das Direktsteckelement, vorkommen. Weiterhin besteht die Gefahr, dass eine Kontaktoberfläche verkratzt oder im Extremfall teilweise abgetragen wird oder eine unerwünschte Verformung auftritt. Hierdurch können Kontaktierungsprobleme vorkommen. Diese Gefahr besteht insbesondere im Anwendungsfall für Fahrzeuge, da hier abgedichtete Steckverbindungen als Schutz gegen Spritzwasser usw. verwendet werden müssen, bei denen der Direktkontakt durch eine Elastomerdichtung hindurch bestückt werden muss.

US 5,676,562 und EP 2 096 718 A1 beschreiben Steckelemente, bei denen während eines Anlieferungszustands bei fehlenden Kontakt zumindest Teile einer Kontaktlamelle nach außen abragen.

### Offenbarung der Erfindung

Das erfindungsgemäße Direktsteckelement mit den Merkmalen des Anspruchs 1 weist demgegenüber den Vorteil auf, dass es vor Beschädigungen sehr gut geschützt ist. Insbesondere ist auch eine Montage durch eine Dichtung hindurch ohne Beschädigung des Direktkontakts möglich. Dies wird erfindungsgemäß dadurch erreicht, dass das Direktsteckelement einen Direktkontakt mit einer Kontaktlamelle und einem Gehäuse (Kontaktkasten) umfasst. Die Kontaktlamelle ist für eine Direktkontaktierung mit einem freiliegenden Kontaktbereich einer Trägerplatte, z.B. einer Leiterplatte oder einem Stanzgitter oder einem Substrat, eingerichtet. Die Kontaktlamelle ist im Gehäuse geschützt angeordnet. Dabei umfasst die Kontaktlamelle einen Kontaktabschnitt und einen Anlageabschnitt, wobei der Anlageabschnitt eingerichtet ist, mit einer Anlagefläche in Kontakt zu treten. Hierdurch wird eine Verformung der Kontaktlamelle derart bewirkt, dass der Kontaktabschnitt vom Gehäuse vorsteht und somit einen Kontakt mit dem Kontaktbereich der Trägerplatte herstellen kann. Somit ist erfindungsgemäß die Kontaktlamelle in einem Anlieferungszustand geschützt im Gehäuse angeordnet. Erst bei einem Kontakt mit einer Anlagefläche wird die Kontaktlamelle zumindest teilweise aus dem Gehäuse ausgestellt, um eine elektrische Kontaktierung mit einem Gegenstück zu ermöglichen.

Die Unteransprüche zeigen bevorzugte Weiterbildungen der Erfindung. Nach einem Exemplar weist die Kontaktlamelle eine im Wesentlichen U-förmige Gestalt auf. Hierdurch kann eine einfach und kostengünstig herzustellende Kontaktlamelle bereitgestellt werden. Insbesondere wenn ein Anlageabschnitt der Kontaktlamelle an einem Verbindungsbereich der beiden Schenkel der U-förmigen Gestalt angeordnet ist, kann eine sehr leichte Ausstellung des Kontaktabschnitts der Kontaktlamelle bei Anlage an einer Anlagefläche erreicht werden.

Weiter bevorzugt umfasst die Kontaktlamelle ferner einen Führungsabschnitt, um eine Verformung der Kontaktlamelle bei Anlage des Anlageabschnitts an einer Anlagefläche zu führen. Hierdurch kann eine definierte Verformung der Kontaktlamelle erreicht werden. Vorzugsweise ist der Führungsabschnitt an der U-förmigen Kontaktlamelle an dem Schenkel angeordnet, an dem der Kontaktabschnitt nicht angeordnet ist. Besonders bevorzugt befindet sich der Führungsabschnitt weiterhin mit einer Innenseite eines Deckels des Gehäuses in Kontakt und wird entlang der Innenseite geführt.

Gemäß der vorliegenden Erfindung ist das Gehäuse im Wesentlichen im Schnitt U-förmig ausgebildet. Gemäss einer weiteren bevorzugten Ausgestaltung der Erfindung ist der Kontaktabschnitt der Kontaktlamelle an einer wandfreien Seite des Gehäuses angeordnet. Dabei sind die beiden Schenkelwände des U-förmigen Gehäuses vorzugsweise länger als eine Abmessung der Kontaktlamellen in Richtung der Schenkel, um einen guten Schutz der Kontaktlamelle zu gewährleisten.

Gemäß einer alternativen Ausgestaltung der Erfindung umfasst das Gehäuse in einer Gehäusewand eine Öffnung, an welcher der Kontaktabschnitt der Kontaktlamelle angeordnet ist. In der Kontaktposition steht dann der Kontaktabschnitt aus der Öffnung in der Gehäusewand vor.

Gemäß einer weiteren bevorzugten Ausgestaltung der vorliegenden Erfindung umfasst das Gehäuse oder ein das Gehäuse umgebendes Zusatzgehäuse, insbesondere ein Kunststoffgehäuse, des Direktsteckelements die Anlagefläche. Alternativ ist die Anlagefläche an einem anderen, separaten Bauteil, beispielsweise einem Gehäuse eines Gegenstücks, an welchem die freiliegenden Kontaktbereiche vorgesehen sind, angeordnet.

Weiter bevorzugt umfasst der Direktkontakt ferner eine Rastvorrichtung, welche eingerichtet ist, eine Verrastung einer Kontaktstellung zwischen der Kontaktlamelle und dem Gehäuse sicherzustellen. Die Rastvorrichtung umfasst vorzugsweise in einem der beiden Bauteile eine Öffnung und in dem anderen der beiden Bauteile eine vorstehende Nase, welche in die Öffnung eingreift. Die vorstehende Nase kann vorzugsweise federnd ausgebildet sein.

Besonders bevorzugt ist die Ausnehmung in der Kontaktlamelle angeordnet und die Rastnase ist am Gehäuse vorgesehen.

Weiterhin betrifft die vorliegende Erfindung eine elektrische Anordnung, umfassend ein erfindungsgemäßes Direktsteckelement sowie ein Gegenstück, insbesondere ein Steuergerät, wobei eine Anlagefläche für das Anliegen des Anlageabschnitts der Kontaktlamelle am Gegenstück, insbesondere am Gehäuse des Steuergeräts, angeordnet ist.

Beispielsweise ist die elektrische Anordnung zur Verwendung in einem Fahrzeug ausgelegt und umfasst ein Steuergerät sowie ein Direktsteckelement.

### Zeichnung

Nachfolgend werden bevorzugte Ausführungsbeispiele der Erfindung unter Bezugnahme auf die begleitende Zeichnung im Detail beschrieben. In der Zeichnung ist:
- Figur 1: eine schematische Schnittansicht eines Direktkontaktes für ein Direktsteckelement gemäß einem ersten Ausführungsbeispiel der Erfindung,
- Figur 2: eine schematische, perspektivische Darstellung des Direktkontaktes von Figur 1,
- Figur 3: eine schematische Ansicht des Direktkontakts von Figur 1 von vorne,
- Figur 4: eine schematische Schnittansicht des in Figur 1 gezeigten Direktsteckelements in einem Kontaktzustand mit einem Gegenstück, und
- Figur 5: eine schematische Schnittansicht eines Direktsteckelements gemäß einem zweiten Ausführungsbeispiel in einem Kontaktzustand mit einem Gegenstück.

### Bevorzugte Ausführungsformen der Erfindung

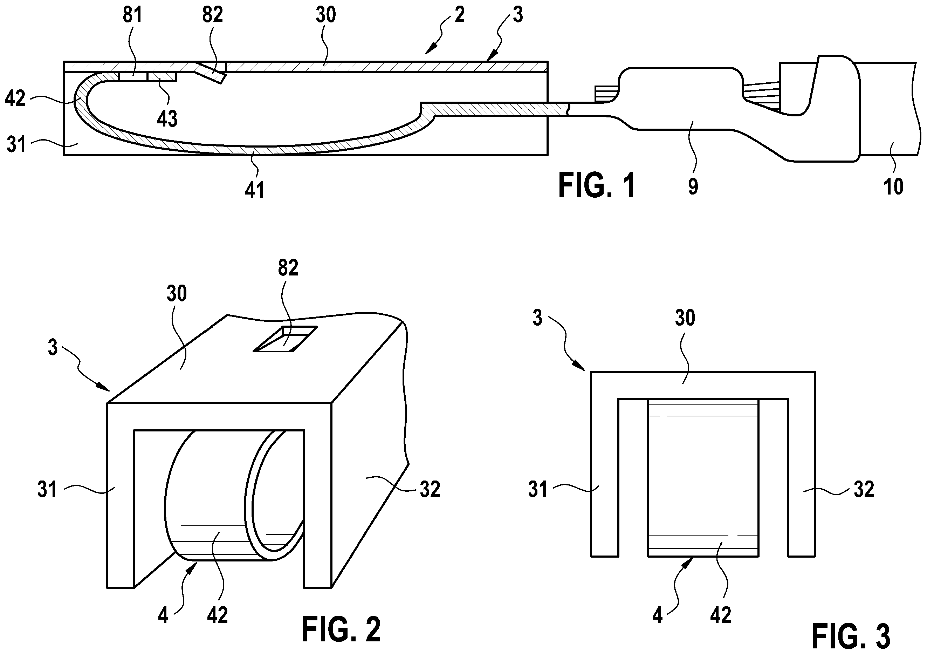

Nachfolgend wird unter Bezugnahme auf die Figuren 1 bis 4 ein Direktsteckelement 1 gemäß einem ersten bevorzugten Ausführungsbeispiel der Erfindung im Detail beschrieben.

Das erfindungsgemäße Direktsteckelement 1 gemäß dem ersten Ausführungsbeispiel umfasst einen Direktkontakt 2 mit einem Kontaktkasten bzw. einem Gehäuse 3 und einer Kontaktlamelle 4. Das Gehäuse 3 und die Kontaktlamelle 4 sind vorzugsweise aus dem gleichen Material hergestellt. Der Direktkontakt 2 ist über eine Crimpverbindung 9 mit einem Kabel 10 elektrisch verbunden.

Wie insbesondere aus den Figuren 2 und 3 ersichtlich ist, weist das Gehäuse 3 im Schnitt eine im Wesentlichen U-förmige Gestalt mit einem ersten Wandbereich 31, einem zweiten Wandbereich 32 und einem Deckel 30 auf, welcher die beiden Wandbereiche miteinander verbindet. Die beiden Wandbereiche 31, 32 weisen dabei jeweils eine Höhe derart auf, dass die Kontaktlamelle 4, wie aus Figur 1 ersichtlich ist, vollständig vom Gehäuse 3 umgeben ist. Hierdurch kann ein exzellenter Schutz der Kontaktlamelle erhalten werden.

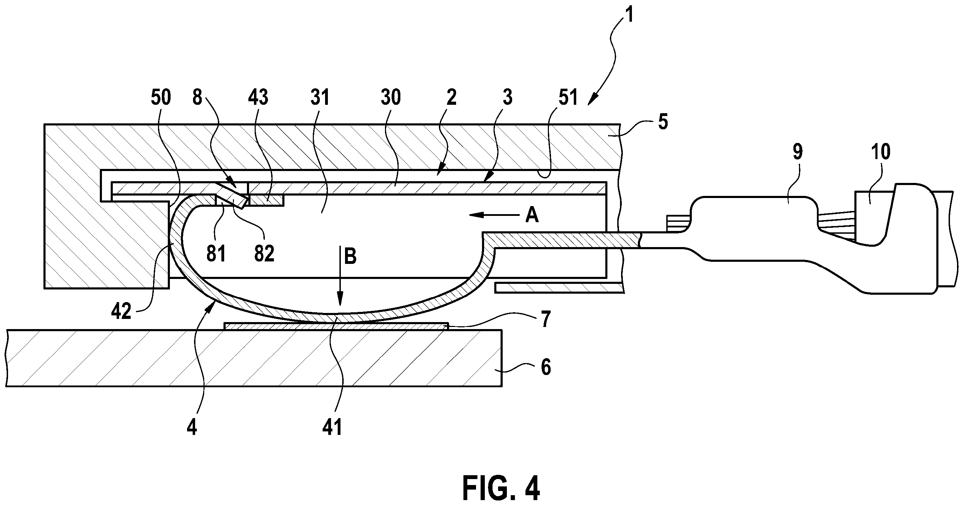

Die Kontaktlamelle 4 weist im Schnitt eine im Wesentlichen U-förmige Form auf und umfasst einen Kontaktabschnitt 41, einen Anlageabschnitt 42 und einen Führungsabschnitt 43. Der Führungsabschnitt 43 liegt lose an der Innenseite des Deckels 30 an. Der Kontaktabschnitt 41 dient zur Ausführung einer Kontaktierung mit einem an einer Leiterplatte 6 freiliegenden Kontaktbereich 7 (vgl. Figur 4). Die beiden Schenkel der U-förmigen Kontaktlamelle 4 sind dabei unterschiedlich lang.

In Figur 4 ist der Kontaktzustand zwischen dem Direktsteckelement 1 und der Leiterplatte 6 dargestellt. Das Direktsteckelement 1 umfasst zusätzlich noch ein Steckergehäuse 5, welches vorzugsweise aus einem Kunststoffmaterial hergestellt ist. Am Steckergehäuse 5 ist eine Anlagefläche 50 vorgesehen, welche senkrecht zu einer Einschubrichtung A des Direktkontakts 2 ist. Bei der Bestückung des Direktsteckelements 1 mit Direktkontakten, werden die Direktkontakte 2 in eine in dem Steckergehäuse 5 gebildete Aufnahme 51 eingeschoben. Gegen Ende des Einschiebevorgangs kommt dann der Anlageabschnitt 42 der Kontaktlamelle 4 mit der Anlagefläche 50 am Steckergehäuse 5 in Kontakt. Hierdurch ergibt sich eine Verformung der Kontaktlamelle 4 derart, dass der Kontaktabschnitt 41 aus dem Gehäuse 3 des Direktkontaktes 2 in Richtung des Pfeils B senkrecht zur Einschubrichtung A herausgedrückt wird. Hierdurch wird erreicht, dass der Kontaktabschnitt 41 der Kontaktlamelle 4 aus dem Direktsteckelement 1 vorsteht. Dadurch kann eine sichere Direktkontaktierung der freiliegenden Kontaktbereiche 7 an der Leiterplatte 6 erreicht werden.

Um diesen Kontaktzustand der Kontaktlamelle 4 zu sichern, ist ferner eine Rastvorrichtung 8 vorgesehen. Die Rastvorrichtung 8 umfasst eine im Führungsabschnitt 43 gebildete Ausnehmung und eine geometrisch entsprechende Ausnehmung gebildete Rastnase 82 an dem Gehäuse 3. Wie insbesondere aus Figur 1 ersichtlich ist, ist die Rastnase 82 vom Deckel 30 in Richtung der Kontaktlamelle 4 herausgedrückt. Die Rastnase 82 kann beispielsweise mittels eines Stanzvorgangs einfach hergestellt werden. Während des Anliegens des Anlageabschnitts 42 an der Anlagefläche 50 führt der Führungsabschnitt 43 dabei die Kontaktlamelle 4 an der Innenseite des Deckels 30. Die Rastvorrichtung 8 ist nun an einer derartigen Position vorgesehen, dass die Ausnehmung 81 genau dann hinter die Rastnase 82 greift, wenn der Kontaktabschnitt 41 um einen vorbestimmten Abstand vom Direktsteckelement 1 vorsteht. Der vorbestimmte Abstand wird dabei derart gewählt, dass eine sichere Direktkontaktierung des Gegenstücks möglich ist.

Somit ist die Kontaktlamelle 4 in einem Anlieferungszustand, welcher in Figur 1 gezeigt ist, innerhalb des Gehäuses 3 geschützt angeordnet. Erst mit dem Einführvorgang des Direktkontaktes 2 in das Steckergehäuse 5 wird der Kontaktabschnitt 41 aus dem Steckergehäuse 5 ausgestellt. Die Rastvorrichtung 8 stellt dabei die ausgerastete Position sicher. Ferner sichert die Rastvorrichtung 8 auch eine gewisse Vorspannkraft während des Kontaktzustandes zwischen der Kontaktlamelle und dem Kontaktbereich 7. Somit weist der Direktkontakt 2 als Schutz ein eigenes Gehäuse 3 auf, welches die Kontaktlamelle 4 vor Beschädigungen schützt.

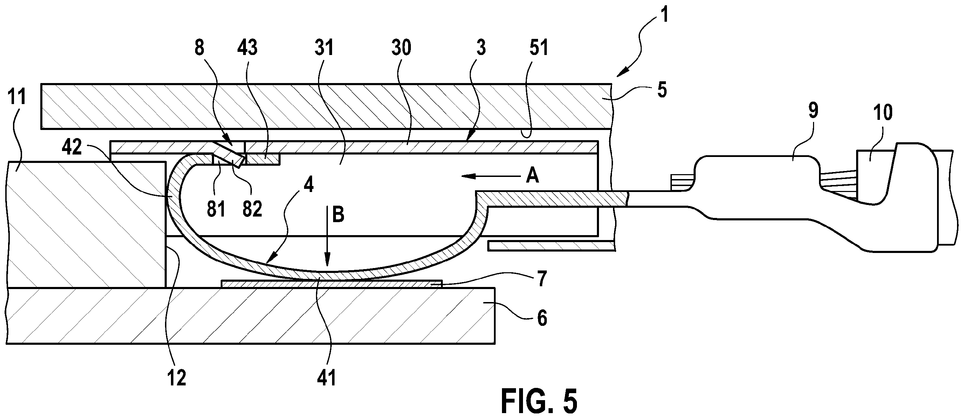

Nachfolgend wird unter Bezugnahme auf Figur 5 ein Direktsteckelement 1 gemäß einem zweiten Ausführungsbeispiel der Erfindung im Detail beschrieben. Gleiche bzw. funktional gleiche Teile sind dabei mit den gleichen Bezugszeichen wie im ersten Ausführungsbeispiel bezeichnet.

Beim zweiten Ausführungsbeispiel ist der Direktkontakt 2 gleich wie im ersten Ausführungsbeispiel aufgebaut. Allerdings dient als Anlagefläche nicht mehr eine am Direktsteckelement 1 integral gebildete Fläche, sondern eine Gehäusefläche 12 eines Gehäuses 11 des Gegenstücks bildet die Anlagefläche. Somit wird beim zweiten Ausführungsbeispiel während des Steckvorgangs, bei dem das Direktsteckelement 1 auf die Leiterplatte 6 aufgesteckt wird, die Kontaktlamelle 4 in den in Figur 5 gezeigten Kontaktzustand verformt. Beim Aufstecken läuft der Auflageabschnitt 42 der Kontaktlamelle 4 auf die Gehäusefläche 12 auf, wird über den Führungsabschnitt 43 an der Innenseite des Deckels 30 geführt und verformt sich dabei derart, dass der Kontaktabschnitt 41 vom Direktsteckelement 1 in Richtung des Pfeils B vorsteht. Die Endposition der Kontaktlamelle 4 wird dann über die Rastvorrichtung 8 gesichert. Dadurch kann beim zweiten Ausführungsbeispiel die geschützte Position der Kontaktlamelle im Gehäuse 3 des Direktkontaktes 2 bis zum Aufsteckvorgang des Direktsteckelements 1 auf die Leiterplatte beibehalten werden. Somit können die Direktsteckelemente 1 mit den Direktkontakten 2 bestückt werden, wobei bis zur Montage des Direktsteckelements die Kontaktlamellen 4 geschützt angeordnet sind.

Ansonsten entspricht dieses Ausführungsbeispiel dem vorhergehenden Ausführungsbeispiel, so dass auf die dort gegebene Beschreibung verwiesen werden kann.

## Patentansprüche

1. Direktsteckelement, umfassend
- einen Direktkontakt (2) mit
- einer Kontaktlamelle (4), welche für eine Direktkontaktierung mit einem freiliegenden Kontaktbereich (7) einer Trägerplatte eingerichtet ist, und
- ein im Schnitt im Wesentlichen U-förmiges Gehäuse (3), in welchem die Kontaktlamelle (4) in einem Anlieferungszustand angeordnet ist,
- wobei die Kontaktlamelle (4) einen Kontaktabschnitt (41) und einen Anlageabschnitt (42) aufweist, und
- wobei der Anlageabschnitt (42) eingerichtet ist, während eines Bestückens des Direktsteckelements (1) mit Direktkontakten (2) durch Einschieben entlang einer Einschubrichtung (A) mit einer senkrecht zu der Einschubrichtung (A) verlaufenden Anlagefläche (12; 50) in Kontakt zu treten, um eine Verformung der Kontaktlamelle (4) derart zu bewirken, dass der Kontaktabschnitt (41) für einen Kontakt mit dem freiliegenden Kontaktbereich (7) senkrecht zu der Einschubrichtung (A) aus dem Gehäuse (3) herausgedrückt wird,
wobei die Kontaktlamelle (4) während des Anlieferungszustands bei fehlendem Kontakt zwischen dem Anlageabschnitt (42) und der Anlagefläche (12, 50) vollständig innerhalb des im Schnitt im Wesentlichen U-förmigen Gehäuses angeordnet ist,
und die Kontaktlamelle (4) derart ausgebildet ist, dass der Kontaktabschnitt (41) erst bei einem Kontakt zwischen dem Anlageabschnitt (42) und der Anlagefläche (12, 50) aus dem im Schnitt im Wesentlichen U-förmigen Gehäuse (3) herausgedrückt wird, um den freiliegenden Kontaktbereich (7) der Trägerplatte zu kontaktieren.

2. Direktsteckelement nach Anspruch 1, **dadurch gekennzeichnet, dass** die Kontaktlamelle (4) ferner einen Führungsabschnitt (43) umfasst.

3. Direktsteckelement nach Anspruch 2, **dadurch gekennzeichnet, dass** der Führungsabschnitt (43) lose an einer Innenseite eines Deckels (30) des Gehäuses (3) anliegt.

4. Direktsteckelement nach einem der vorhergehenden Ansprüche, **dadurch gekennzeichnet, dass** der Kontaktabschnitt (41) der Kontaktlamelle an einer wandfreien Seite des Gehäuses (3) angeordnet ist.

5. Direktsteckelement nach einem der Ansprüche 1 bis 4, **dadurch gekennzeichnet, dass** das Gehäuse (3) in einer Gehäusewand eine Öffnung aufweist, wobei der Kontaktabschnitt (41) an der Öffnung angeordnet ist und im Kontaktzustand mit dem freiliegenden Kontaktbereich (7) aus der Öffnung vorsteht.

6. Direktsteckelement nach einem der vorhergehenden Ansprüche, ferner umfassend eine Rastvorrichtung (8), welche eingerichtet ist, eine Verrastung einer Kontaktstellung zwischen der Kontaktlamelle (4) und dem Gehäuse (3) sicherzustellen.

7. Direktsteckelement nach Anspruch 6, **dadurch gekennzeichnet, dass** die Rastvorrichtung eine Ausnehmung 81, insbesondere an der Kontaktlamelle (4), und eine Rastnase (82), insbesondere am Gehäuse (3), umfasst.

8. Direktsteckelement nach einem der vorhergehenden Ansprüche, **dadurch gekennzeichnet, dass** die Anlagefläche (50) an einem Steckergehäuse (5) gebildet ist.

9. Elektrische Anordnung, umfassend ein Direktsteckelement nach einem der vorhergehenden Ansprüche.

10. Elektrische Anordnung, umfassend ein Direktsteckelement nach einem der Ansprüche 1 bis 8 und ein Gegenstück, insbesondere ein Steuergerät, wobei das Gegenstück eine Anlagefläche (12) für ein Anlegen des Anlageabschnitts (42) der Kontaktlamelle (4) aufweist.

## Claims

1. Direct plug-in element comprising
- a direct contact (2) with
- a contact lamella (4) which is designed to make direct contact with an exposed contact region (7) of a carrier plate, and
- a housing (3) which is substantially U-shaped in section and in which the contact lamella (4) is arranged in a delivery state,
- wherein the contact lamella (4) has a contact section (41) and a bearing section (42), and
- wherein the bearing section (42), during fitting of the direct plug-in element (1) with direct contacts (2), is designed to come into contact with a bearing face (12; 50), which runs perpendicular to an insertion direction (A), by way of insertion along the insertion direction (A), in order to effect deformation of the contact lamella (4) in such a way that the contact section (41) for contact with the exposed contact region (7) is pushed out of the housing (3) perpendicular to the insertion direction (A),
wherein the contact lamella (4), during the delivery state when there is no contact between the bearing section (42) and the bearing face (12, 50), is arranged entirely within the housing which is substantially U-shaped in section,
and the contact lamella (4) is designed in such a way that the contact section (41) is pushed out of the housing (3) which is substantially U-shaped in section only when contact is made between the bearing section (42) and the bearing face (12, 50), in order to make contact with the exposed contact region (7) of the carrier plate.

2. Direct plug-in element according to Claim 1, **characterized in that** the contact lamella (4) further comprises a guide section (43).

3. Direct plug-in element according to Claim 2, **characterized in that** the guide section (43) bears loosely against an inner side of a cover (30) of the housing (3).

4. Direct plug-in element according to one of the preceding claims, **characterized in that** the contact section (41) of the contact lamella (4) is arranged on a wall-free side of the housing (3).

5. Direct plug-in element according to one of Claims 1 to 4, **characterized in that** the housing (3) has an opening in a housing wall, wherein the contact section (41) is arranged at the opening and protrudes out of the opening in the state of contact with the exposed contact region (7).

6. Direct plug-in element according to one of the preceding claims, further comprising a latching apparatus (8) which is designed to ensure latching of a contact position between the contact lamella (4) and the housing (3).

7. Direct plug-in element according to Claim 6, **characterized in that** the latching apparatus comprises a recess (81), in particular in the contact lamella (4), and a latching lug (82), in particular on the housing (3).

8. Direct plug-in element according to one of the preceding claims, **characterized in that** the bearing face (50) is formed on a plug housing (5).

9. Electrical arrangement comprising a direct plug-in element according to one of the preceding claims.

10. Electrical arrangement comprising a direct plug-in element according to one of Claims 1 to 8 and a mating piece, in particular a controller, wherein the mating piece has a bearing face (12) for application of the bearing section (42) of the contact lamella (4).

## Revendications

1. Élément à insertion directe, comprenant
- un contact direct (2) avec
- une lamelle de contact (4) qui est conçue pour l'établissement d'un contact direct avec une zone de contact (7) dégagée d'une plaque porteuse, et
- un boîtier (3) dont la coupe est sensiblement en forme de U, dans lequel est disposée la lamelle de contact (4) dans un état à la livraison,
- la lamelle de contact (4) possédant une portion de contact (41) et une portion d'application (42), et
- la portion d'application (42) étant conçue pour, pendant un équipement de l'élément à insertion directe (1) avec des contacts directs (2) par insertion le long d'un sens d'insertion (A), entrer en contact avec une surface d'application (12, 50) qui s'étend perpendiculairement au sens de l'insertion (A) afin de provoquer une déformation de la lamelle de contact (4) de telle sorte que la portion de contact (41) est poussée vers l'extérieur hors du boîtier (3) perpendiculairement au sens de l'insertion (A) pour un contact avec la zone de contact (7) dégagée,
la lamelle de contact (4), pendant l'état à la livraison en l'absence de contact entre la portion d'application (42) et la surface d'application (12, 50), étant entièrement disposée à l'intérieur du boîtier (3) dont la coupe est sensiblement en forme de U,
et la lamelle de contact (4) étant configurée de telle sorte que la portion de contact (41) n'est poussée hors du boîtier (3) dont la coupe est sensiblement en forme de U que lors d'un contact entre la portion d'application (42) et la surface d'application (12, 50) afin d'entrer en contact avec la zone de contact (7) dégagée de la plaque porteuse.

2. Élément à insertion directe selon la revendication 1, **caractérisé en ce que** la lamelle de contact (4) comprend en outre une portion de guidage (43).

3. Élément à insertion directe selon la revendication 2, **caractérisé en ce que** la portion de guidage (43) repose de manière détachée sur un côté intérieur d'un couvercle (30) du boîtier (3).

4. Élément à insertion directe selon l'une des revendications précédentes, **caractérisé en ce que** la portion de contact (41) de la lamelle de contact est disposée sur un côté exempt de paroi du boîtier (3).

5. Élément à insertion directe selon l'une des revendications 1 à 4, **caractérisé en ce que** le boîtier (3) possède une ouverture dans une paroi de boîtier, la portion de contact (41) étant disposée au niveau de l'ouverture et dépasse hors de l'ouverture en situation de contact avec la zone de contact (7) dégagée.

6. Élément à insertion directe selon l'une des revendications précédentes, comprenant en outre un dispositif d'encliquetage (8) qui est conçu pour garantir un encliquetage d'une position de contact entre la lamelle de contact (4) et le boîtier (3).

7. Élément à insertion directe selon la revendication 6, **caractérisé en ce que** le dispositif d'encliquetage comprend une cavité (81), notamment au niveau de la lamelle de contact (4), et un tenon d'encliquetage (82), notamment au niveau du boîtier (3).

8. Élément à insertion directe selon l'une des revendications précédentes, **caractérisé en ce que** la surface d'application (50) est formée sur un boîtier de fiche (5).

9. Arrangement électrique comprenant un élément à insertion directe selon l'une des revendications précédentes.

10. Arrangement électrique comprenant un élément à insertion directe selon l'une des revendications 1 à 8 et une pièce homologue, notamment un contrôleur, la pièce homologue possédant une surface d'application (12) pour une application de la portion d'application (42) de la lamelle de contact (4).
